# EUROPEAN PATENT APPLICATION

(11) **EP 4 391 255 A1**
(43) Date of publication of application: **26.06.2024**
(21) Application number: 22909609.4
(22) Date of filing: 18.11.2022
(51) Int. Cl.: H02B 1/24, H01M 50/519

(54) **POWER DISTRIBUTION APPARATUS, BATTERY PACK AND VEHICLE**

(30) Priority: 20.12.2021 CN 202123233795 U; 25.02.2022 CN 202210182099
(71) Applicant: BYD Company Limited, Shenzhen, Guangdong 518118 (CN)
(72) Inventor: GAO, Jian, Shenzhen, Guangdong 518118 (CN); E, Congji, Shenzhen, Guangdong 518118 (CN); ZHAO, Xiaopeng, Shenzhen, Guangdong 518118 (CN); PENG, Qingbo, Shenzhen, Guangdong 518118 (CN); WU, Zhenhan, Shenzhen, Guangdong 518118 (CN); WANG, Chengzhi, Shenzhen, Guangdong 518118 (CN)
(74) Representative: Dehns Germany Partnerschaft mbB
(86) International application number: PCT/CN2022/132834
(87) International publication number: WO 2023/116293

(57) **Abstract**

The present disclosure provide a power distribution apparatus, a battery pack, and a vehicle. The power distribution apparatus includes: a base, a high-voltage connection part and a low-voltage connection part being fixed on the base; a high-voltage loop, at least a portion of the high-voltage loop being arranged on the base, the high-voltage loop being electrically connected to the high-voltage connection part, the high-voltage loop having a module positive-electrode connection end and a module negative-electrode connection end, and the high-voltage loop including a main disconnecting switch core fixed on the base; a circuit board, the circuit board being arranged on the base; a low-voltage loop, the low-voltage loop being integrated into the circuit board and being electrically connected to the low-voltage connection part; and a plurality of high-and-low-voltage tabs, an end of each high-and-low-voltage tab being connected to the high-voltage loop for electrical connection, and another end of the high-and-low-voltage tab being plugged into the circuit board for electrical connection with the low-voltage loop. The power distribution apparatus in the embodiments of the present disclosure has advantages such as a simple and compact structure, high space utilization, a small volume, a light weight, and low costs.

## Description

### CROSS-REFERENCE TO RELATED APPLICATIONS

The present disclosure claims priority to Chinese Patent Application No. 202123233795.5, entitled "BATTERY DISCONNECT UNIT FOR POWER BATTERY SYSTEM" filed on December 20, 2021 and Chinese Patent Application No. 202210182099.6, entitled "POWER DISTRIBUTION APPARATUS, BATTERY PACK, AND VEHICLE" filed on February 25, 2022, which are incorporated by reference in their entireties.

### FIELD

The present disclosure relates to the technical field of vehicles, and more specifically, to a power distribution apparatus, a battery pack, and a vehicle.

### BACKGROUND

A battery disconnect unit in related art usually includes a high-voltage circuit, a low-voltage circuit, a high-voltage connector and a low-voltage connector. In addition, there are many copper bars or wire harnesses between the components in the battery disconnect unit, resulting in a chaotic layout, a large occupied space, low space utilization, high costs, a heavy weight, a large volume, and low production efficiency.

### SUMMARY

The present disclosure aims to resolve at least one of the technical problems in the related art. To this end, the present disclosure proposes a power distribution apparatus that has advantages such as a simple and compact structure, high space utilization, a small size, a light weight, and low costs.

The present disclosure further proposes a battery pack having the above power distribution apparatus.

The present disclosure further proposes a vehicle having the above battery pack.

An embodiment of a first aspect of the present disclosure provides a power distribution apparatus, including: a base, a high-voltage connection part and a low-voltage connection part being fixed on the base; a high-voltage loop, at least a part of the high-voltage loop being arranged on the base, the high-voltage loop being electrically connected to the high-voltage connection part, the high-voltage loop having a module positive-electrode connection end and a module negative-electrode connection end, and the high-voltage loop including a main disconnecting switch core fixed on the base; a circuit board, the circuit board being arranged on the base; a low-voltage loop, the low-voltage loop being integrated into the circuit board and being electrically connected to the low-voltage connection part; and a plurality of high-and-low-voltage tabs, a first end of each high-and-low-voltage tab being connected to the high-voltage loop for electrical connection, and a second end of the high-and-low-voltage tab being plugged into the circuit board for electrical connection with the low-voltage loop.

According to some embodiments of the present disclosure, the plurality of high-and-low-voltage tabs are parallel to each other and perpendicular to the circuit board.

According to some embodiments of the present disclosure, the high-voltage loop overlaps with the high-voltage connection part for electrical connection, the low-voltage connection part is plugged into the circuit board for electrical connection with the low-voltage loop, and components connected in the high-voltage loop overlap with each other for electrical connection.

According to some embodiments of the present disclosure, the high-voltage loop further includes a circuit protector, the circuit protector is arranged on the base, and a first terminal of the circuit protector forms the module positive-electrode connection end; the main disconnecting switch core includes a plurality of main disconnecting switch cores, the plurality of main disconnecting switch cores include at least a main positive disconnecting switch core and a main negative disconnecting switch core, a second terminal of the circuit protector is electrically connected to a first terminal of the main positive disconnecting switch core, and a second terminal of the main positive disconnecting switch core and a first terminal of the main negative disconnecting switch core are respectively electrically connected to the high-voltage connection part; and the plurality of high-and-low-voltage tabs include a main positive low-voltage positive-electrode tab, a main positive low-voltage negative-electrode tab, a main negative low-voltage positive-electrode tab, and a main negative low-voltage negative-electrode tab, a first end of the main positive low-voltage positive-electrode tab and a first end of the main positive low-voltage negative-electrode tab are respectively connected to the main positive disconnecting switch core, a second end of the main positive low-voltage positive-electrode tab and a second end of the main positive low-voltage negative-electrode tab are respectively plugged into the circuit board and are electrically connected to the low-voltage loop, a first end of the main negative low-voltage positive-electrode tab and a first end of the main negative low-voltage negative-electrode tab are respectively connected to the main negative disconnecting switch core, and a second end of the main negative low-voltage positive-electrode tab and a second end of the main negative low-voltage negative-electrode tab are respectively plugged into the circuit board for electrical connection with the low-voltage loop.

According to some embodiments of the present disclosure, the second terminal of the circuit protector overlaps with the first terminal of the main positive disconnecting switch core for electrical connection; and the second terminal of the main positive disconnecting switch core and the first terminal of the main negative disconnecting switch core respectively overlap with the high-voltage connection part for electrical connection.

According to some embodiments of the present disclosure, the plurality of high-and-low-voltage tabs further include: a positive-electrode voltage collection piece, a first end of the positive-electrode voltage collection piece being overlapped at an overlapping position between the second terminal of the main positive disconnecting switch core and the high-voltage connection part, and a second end of the positive-electrode voltage collection piece being plugged into the circuit board and being electrically connected to the low-voltage loop; and a negative-electrode voltage collection piece, a first end of the negative-electrode voltage collection piece being overlapped at an overlapping position between the first terminal of the main negative disconnecting switch core and the high-voltage connection part, and a second end of the negative-electrode voltage collection piece being plugged into the circuit board and being electrically connected to the low-voltage loop.

According to some embodiments of the present disclosure, the high-voltage connection part includes: a high-voltage positive-electrode lead-out piece, the high-voltage positive-electrode lead-out piece overlapping with the second terminal of the main positive disconnecting switch core and an end of the positive-electrode voltage collection piece for electrical connection; and a high-voltage negative-electrode lead-out piece, the high-voltage negative-electrode lead-out piece overlapping with the first terminal of the main negative disconnecting switch core and an end of the negative-electrode voltage collection piece for electrical connection.

According to some embodiments of the present disclosure, the second terminal of the main positive disconnecting switch core, the high-voltage positive-electrode lead-out piece, and the end of the positive-electrode voltage collection piece overlap with each other in sequence, one of the high-voltage positive-electrode lead-out piece and the positive-electrode voltage collection piece is provided with a positive-electrode anti-rotation positioning groove, and the other of the high-voltage positive-electrode lead-out piece and the positive-electrode voltage collection piece mates with the positive-electrode anti-rotation positioning groove; and the first terminal of the main negative disconnecting switch core, the high-voltage negative-electrode lead-out piece, and the end of the negative-electrode voltage collection piece overlap with each other in sequence, one of the high-voltage negative-electrode lead-out piece and the negative-electrode voltage collection piece is provided with a negative-electrode anti-rotation positioning groove, and the other of the high-voltage negative-electrode lead-out piece and the negative-electrode voltage collection piece mates with the negative-electrode anti-rotation positioning groove.

According to some embodiments of the present disclosure, the base is configured with a first positioning separation rib and a second positioning separation rib, the first positioning separation rib is located between the circuit protector and the high-voltage positive-electrode lead-out piece and between the circuit protector and the positive-electrode voltage collection piece; and the second positioning separation rib is located between the high-voltage positive-electrode lead-out piece and the high-voltage negative-electrode lead-out piece and between the positive-electrode voltage collection piece and the negative-electrode voltage collection piece.

According to some embodiments of the present disclosure, the high-voltage loop further includes a current sensor, a first terminal of the current sensor forming the module negative-electrode connection end, and a second terminal of the current sensor being electrically connected to the second terminal of the main negative disconnecting switch core; and the plurality of high-and-low-voltage tabs further include a current collection pin, a first end of the current collection pin is connected to the current sensor, and a second end of the current collection pin is plugged into the circuit board and is electrically connected to the low-voltage loop.

According to some embodiments of the present disclosure, the second terminal of the current sensor overlaps with the second terminal of the main negative disconnecting switch core for electrical connection.

According to some embodiments of the present disclosure, the base is configured with a third positioning separation rib, and the third positioning separation rib is located between the current sensor and the high-voltage connection part.

According to some embodiments of the present disclosure, the circuit protector, the main positive disconnecting switch core, the main negative disconnecting switch core and the current sensor are arranged in sequence along a length direction of the base; and the low-voltage connection part and the current sensor are arranged along a width direction of the base.

According to some embodiments of the present disclosure, the high-voltage loop further includes a precharge loop, a portion of the precharge loop is integrated into the circuit board, the precharge loop includes a precharge resistor and a precharge disconnecting switch, the precharge resistor and the precharge disconnecting switch are arranged on the base and plugged into the circuit board, and the precharge resistor and the precharge disconnecting switch are connected in series to each other and in parallel with the main disconnecting switch core; and the plurality of high-and-low-voltage tabs further include a precharge low-voltage positive-electrode tab and a precharge low-voltage negative-electrode tab, a first end of the precharge low-voltage positive-electrode tab and a first end of the precharge low-voltage negative-electrode tab are respectively connected to the precharge disconnecting switch, and a second end of the precharge low-voltage positive-electrode tab and a second end of the precharge low-voltage negative-electrode tab are respectively plugged into the circuit board for electrical connection with the low-voltage loop.

According to some embodiments of the present disclosure, the precharge disconnecting switch has a precharge high-voltage positive-electrode tab and a precharge high-voltage negative-electrode tab, the precharge resistor has a resistor high-voltage tab, the precharge disconnecting switch and the precharge resistor are electrically connected to each other through contact, and the precharge high-voltage positive-electrode tab, the precharge high-voltage negative-electrode tab, and the resistor high-voltage tab are plugged into the circuit board for electrical connection with a portion of the precharge loop integrated on the circuit board. Optionally, the precharge disconnecting switch has the precharge high-voltage positive-electrode tab and the precharge high-voltage negative-electrode tab, the precharge resistor has a resistor high-voltage positive-electrode tab and a resistor high-voltage negative-electrode tab, and the precharge high-voltage positive-electrode tab, the precharge high-voltage negative-electrode tab, the resistor high-voltage positive-electrode tab, and the resistor high-voltage negative-electrode tab are plugged into the circuit board for electrical connection with a portion of the precharge loop integrated on the circuit board.

According to some embodiments of the present disclosure, the precharge loop further includes: a precharge tab, the second terminal of the circuit protector overlapping with the first terminal of the main positive disconnecting switch core for electrical connection, a first end of the precharge tab being overlapped at an overlapping position between the second terminal of the circuit protector and the first terminal of the main positive disconnecting switch core, and a second end of the precharge tab being plugged into the circuit board and electrically connected to a portion of the precharge loop integrated on the circuit board.

According to some embodiments of the present disclosure, the precharge tab is integrally formed with the second terminal of the circuit protector.

According to some embodiments of the present disclosure, the precharge disconnecting switch, the precharge resistor, the main positive disconnecting switch core, the main negative disconnecting switch core, and the low-voltage connection part are arranged in sequence along the length direction of the base; and the precharge disconnecting switch, the precharge resistor and the circuit protector are arranged along the width direction of the base.

According to some embodiments of the present disclosure, the base is configured with a main positive disconnecting switch core installation groove, a main negative disconnecting switch core installation groove, a precharge disconnecting switch installation groove, and a precharge resistor installation groove; the main positive disconnecting switch core is fixed to the main positive disconnecting switch core installation groove through thermal conductive potting of glue; the main negative disconnecting switch core is fixed to the main negative disconnecting switch core installation groove through thermal conductive potting of glue; the precharge disconnecting switch is clamped in the precharge disconnecting switch installation groove or fixed to the precharge disconnecting switch installation groove through thermal conductive potting of glue; and the precharge resistor is clamped in the precharge resistor installation groove.

According to some embodiments of the present disclosure, the base includes: a base body, at least a portion of the high-voltage loop being arranged on the base body, and the circuit board being arranged on the base body; and a panel, the panel being connected to the base body, and the high-voltage connection part and the low-voltage connection part being fixed on the panel.

According to some embodiments of the present disclosure, the base body and the panel are one piece or separate pieces.

An embodiment of a second aspect of the present disclosure provides a battery pack, including: a housing; the power distribution apparatus according to the embodiments of the first aspect of the present disclosure, the power distribution apparatus being arranged in the housing, and the high-voltage connection part and the low-voltage connection part being exposed from the housing; and a battery module, the battery module being located in the housing and electrically connected to the module positive-electrode connection end and the module negative-electrode connection end respectively.

An embodiment of a third aspect of the present disclosure provides a vehicle, including the battery pack according to the embodiments of the second aspect of the present disclosure.

The additional aspects and advantages of the present disclosure will be provided in the following description, some of which will become apparent from the following description or may be learned from practices of the present disclosure.

### BRIEF DESCRIPTION OF THE DRAWINGS

The foregoing and/or additional aspects and advantages of the present disclosure will become apparent and comprehensible from the following descriptions of the embodiments with reference to the accompanying drawings, where:
FIG. 1 is a schematic structural diagram of a power distribution apparatus according to an embodiment of the present disclosure;
FIG. 2 is a schematic structural diagram of another perspective of a power distribution apparatus according to an embodiment of the present disclosure;
FIG. 3 is a schematic structural diagram of a power distribution apparatus according to another embodiment of the present disclosure;
FIG. 4 is an exploded view of a power distribution apparatus according to an embodiment of the present disclosure;
FIG. 5 is a schematic structural diagram of a base of a power distribution apparatus according to an embodiment of the present disclosure;
FIG. 6 is a schematic structural diagram of a base of a power distribution apparatus from another perspective according to an embodiment of the present disclosure;
FIG. 7 is a schematic diagram of a circuit principle of a power distribution apparatus according to an embodiment of the present disclosure;
FIG. 8 is a schematic structural diagram of a power distribution apparatus according to another embodiment of the present disclosure; and
FIG. 9 is a schematic structural diagram of a vehicle according to an embodiment of the present disclosure.

Descriptions of reference numerals:
1-power distribution apparatus, 2-battery pack, 3-vehicle, 100-base,101-main positive disconnecting switch core installation groove, 102-main negative disconnecting switch core installation groove, 103-precharge disconnecting switch installation groove, 104-precharge resistor installation groove, 105-base, 106-panel, 110-high-voltage connection part, 111-high-voltage positive-electrode lead-out piece, 112-high-voltage negative-electrode lead-out piece, 120-low-voltage connection part, 130-first positioning separation rib, 140-second positioning separation rib, 150-current sensor, 160-third positioning separation rib, 170-precharge loop, 171-precharge tab, 180-precharge resistor, 181-resistor high-voltage tab, 182-resistor high-voltage positive-electrode tab, 183-resistor high-voltage negative-electrode tab, 190-precharge disconnecting switch, 191-precharge high-voltage positive-electrode tab, 192-precharge high-voltage negative-electrode tab, 200-high-voltage loop, 210-module positive-electrode connection end, 220-module negative-electrode connection end, 230-main disconnecting switch core, 231-main positive disconnecting switch core, 232-main negative disconnecting switch core, 240-circuit protector, 300-circuit board, 400-low-voltage loop, 500-high-and-low-voltage tab, 510-main positive low-voltage positive-electrode tab, 520-main positive low-voltage negative-electrode tab, 530-main negative low-voltage positive-electrode tab, 540-main negative low-voltage negative-electrode tab, 550-positive-electrode voltage collection piece, 560-negative-electrode voltage collection piece, 570-current collection pin, 580-precharge low-voltage positive-electrode tab, 590-precharge low-voltage negative-electrode tab, 700-battery module, 800-housing, and 900-load.

### DETAILED DESCRIPTION

Embodiments of the present disclosure will be described below in detail, and examples of the embodiments are shown in the drawings, where the same or similar reference numerals throughout the drawings represent the same or similar elements or the elements having the same or similar functions. The embodiments described below with reference to the accompanying drawings are exemplary, and are merely intended to explain the present disclosure and cannot be construed as a limitation to the present disclosure.

In the description of the present disclosure, it needs to be understood that the directions or positional relationships indicated by terms such as "center", "longitudinal", "horizontal", "length", "width", "thickness", "upper", "lower", "front", "rear", "left", "right", "vertical", "horizontal", "top", "bottom", "inside", "outside", "clockwise", "counterclockwise", "axial", "radial", and "circumferential" are based on those shown in the accompanying drawings, and are only to facilitate the description of the present disclosure and simplify the description, and do not indicate or imply that the apparatus or component must have a specific orientation, be constructed and operated in a specific orientation, and therefore cannot be understood as limiting the present disclosure.

In the description of the present disclosure, "a plurality of" means two or more than two, and "several" means one or more.

A battery pack 2 according to the embodiments of the present disclosure is described below with reference to the accompanying drawings. The battery pack 2 includes a housing 800, a battery module 700, and a power distribution apparatus 1.

The power distribution apparatus 1 according to the embodiments of the present disclosure is first described with reference to the accompanying drawings.

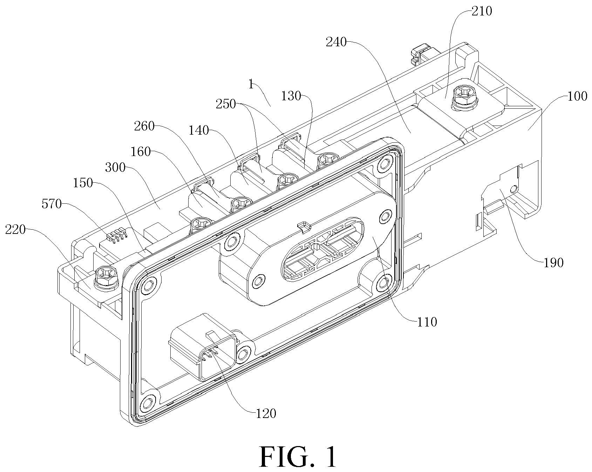

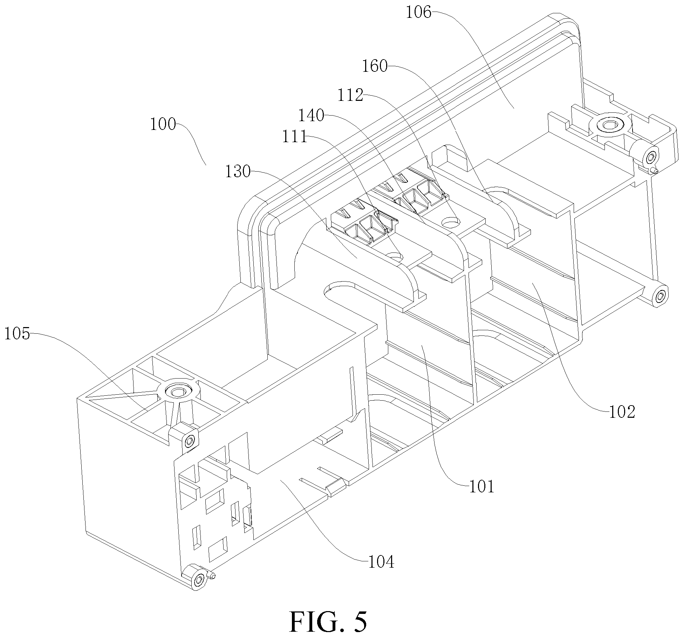

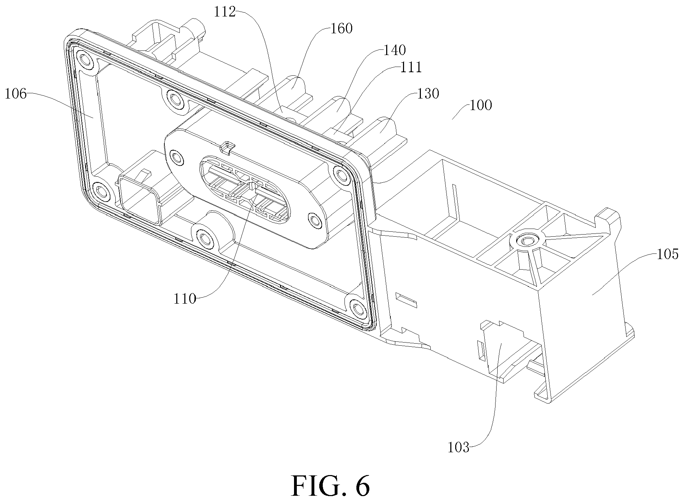

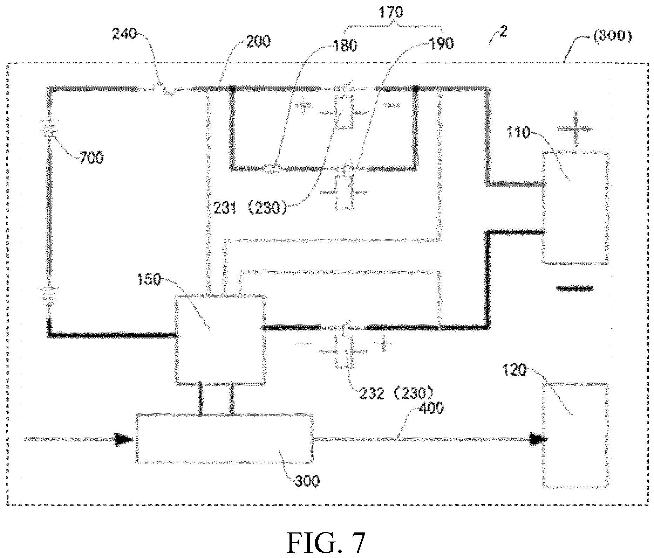

As shown in FIG. 1 to FIG. 8, the power distribution apparatus 1 according to the embodiments of the present disclosure includes a base 100, a high-voltage loop 200, a circuit board 300, a low-voltage loop 400, and a plurality of high-and-low-voltage tabs 500.

A high-voltage connection part 110 and a low-voltage connection part 120 are fixed on the base 100. At least a portion of the high-voltage loop 200 is arranged on the base 100, the high-voltage loop 200 is electrically connected to the high-voltage connection part 110, the high-voltage loop 200 has a module positive-electrode connection end 210 and a module negative-electrode connection end 220, and the high-voltage loop 200 includes a main disconnecting switch core 230 fixed on the base 100; the circuit board 300 is arranged on the base 100; and the low-voltage loop 400 is integrated into the circuit board 300 and is electrically connected to the low-voltage connection part 120. A first end of each high-and-low-voltage tab 500 is connected to the high-voltage loop 200 for electrical connection, and a second end of the high-and-low-voltage tab is plugged into the circuit board 300 for electrical connection with the low-voltage loop 400.

It should be noted that for the term "main disconnecting switch core 230", a main disconnecting switch may include but is not limited to one or more of a relay, an IGBT (Insulated Gate Bipolar Transistor, Insulated Gate Bipolar Transistor), and a MOS field-effect transistor (Metal-Oxide-Semiconductor Field-Effect Transistor, MOSFET). "Core" refers to a part of the main disconnecting switch that mainly implements its function, and can be understood as the internal functional component of the main disconnecting switch after removing its housing, that is, the main disconnecting switch core 230 may be the remaining part after removing the housing of the main disconnecting switch. In addition, the circuit board 300 can be integrated with a battery management controller (Battery Management Controller, BMC).

In the battery pack 2 of the embodiments of the present disclosure, the power distribution apparatus 1 is provided in the housing, the high-voltage connection part 110 and the low-voltage connection part 120 are exposed from the housing, and the battery module 700 is located in the housing and is respectively electrically connected to the module positive-electrode connection end 210 and the module negative-electrode connection end 220. The high-voltage connection part 110 and the low-voltage connection part 120 are exposed from the housing to connect to electrical components of the vehicle (for example, a motor, an air conditioning compressor, a PTC (Positive Temperature Coefficient), or a controller).

For example, the high-voltage loop 200 and the low-voltage loop 400 are not directly connected to each other, and instead a transformer structure (that is, a structure that can change the voltage) is connected between the high-voltage loop 200 and the low-voltage loop 400, for example, a transformer is connected between the high-voltage loop 200 and the low-voltage loop 400. The setting of the transformer structure can ensure that the voltage of the current in the low-voltage loop 400 is lower than the voltage of the current in the high-voltage loop 200, and the battery module 700 can supply power to the low-voltage loop 400 through the high-voltage loop 200 and the transformer structure, to achieve normal operation of the low-voltage loop 400.

According to the power distribution apparatus 1 of the embodiments of the present disclosure, the high-voltage connection part 110 and the low-voltage connection part 120 are fixed on the base 100, and the high-voltage connection part 110 and the low-voltage connection part 120 may be exposed from the housing. The high-voltage connection part 110 can supply power to high-voltage electrical devices of the vehicle. The low-voltage connection part 120 can include a communication pin for communicating with a controller of the vehicle to achieve real-time control over the power distribution apparatus 1, and the low-voltage connection part 120 may also include a low-voltage plug for supplying power to low-voltage electrical devices of the vehicle. Furthermore, the base 100 can fix positions of the high-voltage connection part 110 and the low-voltage connection part 120 relative to the base 100, to avoid contact between the high-voltage connection part 110 and the low-voltage connection part 120 to ensure the safety of the electrical connection of the power distribution apparatus 1. The high-voltage connection part 110, the low-voltage connection part 120 and the base 100 can be designed separately to enhance connection flexibility. The battery module 700 can supply power to the high-voltage loop 200 through the module positive-electrode connection end 210 and the module negative-electrode connection end 220, and the high-voltage loop 200 can supply power to high-voltage electrical devices of the vehicle through the high-voltage connection part 110.

Moreover, the base 100 is configured to directly fix the main disconnecting switch core 230. The main disconnecting switch core 230 can have a sufficiently long lead-out part while space is saved. The main disconnecting switch core 230 is directly used and the base 100 is configured to fix and protect the main disconnecting switch core 230, thus eliminating the original housing of the existing disconnecting switch and making the structure simple and more compact.

The low-voltage loop 400 is integrated into the circuit board 300, the circuit board 300 is arranged on the base 100, and the main disconnecting switch core 230 can have a sufficiently long lead-out part, creating a prerequisite for eliminating a large number of copper bars and wire harnesses inside the power distribution apparatus 1. On this basis, the high-and-low-voltage tab 500 is arranged, a first end of each high-and-low-voltage tab 500 is connected to the high-voltage loop 200 for electrical connection, and a second end of the high-and-low-voltage tab is plugged into the circuit board 300 for electrical connection with the low-voltage loop 400.

In other words, the first end of each high-and-low-voltage tab 500 can be connected to the high-voltage loop 200, and the second end of each high-and-low-voltage tab 500 can be directly plugged into the circuit board 300, thereby implementing the connection between the high-voltage loop 200 and the low-voltage loop 400. The low-voltage loop 400 on the circuit board 300 can control the connection and disconnection of the main disconnecting switch core 230, which can eliminate the need for existing intermediate connectors (for example, copper bars and wire harnesses) for high and low voltage connections.

As can be seen from above, the electrical connection between the high-voltage loop 200 and the low-voltage loop 400 is more reliable, the layout is clear, and it is not prone to problems such as excessive temperature rise or sintering at the connection point. By eliminating a large number of copper bars and wire harnesses in the existing power distribution apparatus 1, the layout of electrical connections in the power distribution apparatus 1 can be further simplified and the structure is simple and compact, thereby further reducing the volume of the power distribution apparatus 1, improving the space utilization of the power distribution apparatus 1, and reducing the weight and costs of the power distribution apparatus 1, so as to further save the space of the battery pack 2, improve the energy density of the battery pack 2 and improve the battery endurance of the entire vehicle.

In this way, the power distribution apparatus 1 in the embodiments of the present disclosure has advantages such as a simple and compact structure, high space utilization, a small volume, a light weight, and low costs.

In the battery pack 2 according to the embodiments of the present disclosure, the power distribution apparatus 1 in the embodiments of the present disclosure is used, which has advantages such as a simple and compact structure, high space utilization, a small size, a light weight, and low costs.

According to some specific embodiments of the present disclosure, as shown in FIG. 1 to FIG. 4, a plurality of high-and-low-voltage tabs 500 are parallel to each other and perpendicular to the circuit board 300. A region where the high-voltage loop 200 is arranged is generally parallel to the circuit board 300, and each high-and-low-voltage tab 500 is arranged perpendicular to the circuit board 300. On the one hand, the size of the high-and-low-voltage tab 500 between the high-voltage loop 200 and the circuit board 300 can be reduced, and the volume of the high-and-low-voltage tab 500 can be reduced. On the other hand, this can avoid interference between a plurality of high-and-low-voltage tabs 500, reduce the difficulty of circuit connection, and further simplify the layout.

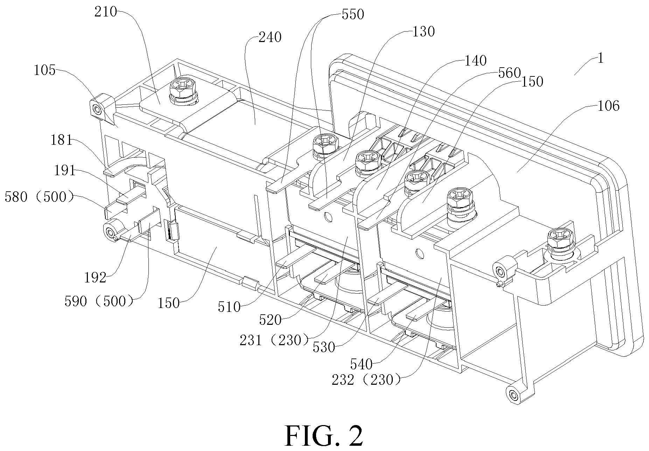

According to some specific embodiments of the present disclosure, as shown in FIG.2 to FIG. 4, the high-voltage loop 200 overlaps with the high-voltage connection part 110 for electrical connection. Since the main disconnecting switch core 230 may have a sufficiently long lead-out part, overlapping can be implemented between the high-voltage loop 200 and the high-voltage connection part 110 through partial superimposing. Electrical connection is achieved through this overlapping, thus eliminating the existing intermediate connector between the high-voltage loop and the high-voltage connection part, that is, copper bars and wire harnesses in the high-voltage part.

In addition, the low-voltage connecting part 120 is plugged into the circuit board 300 for electrical connection with the low-voltage loop 400. That is, the low-voltage loop 400 and the low-voltage connecting part 120 can be electrically connected through the circuit board 300, thus eliminating the existing intermediate connector between the low-voltage loop and the low-voltage connection part, that is, copper bars and wire harnesses in the low-voltage part. Moreover, components connected in the high-voltage loop 200 can be electrically connected through overlapping, that is, overlapping can be implemented through partial superimposing between the components that need to be connected in the high-voltage loop 200. Electrical connection is achieved through this overlapping, thus eliminating the existing intermediate connector in the high-voltage loop, that is, copper bars and wire harnesses in the high-voltage part.

As can be seen from above, the electrical connection between the high-voltage loop 200 and the high-voltage connection part 110, between components connected in the high-voltage loop 200, and between the low-voltage loop 400 and the low-voltage connection part 120 is more reliable, the layout is clear, and it is not prone to problems such as excessive temperature rise or sintering at the connection point. By eliminating a large number of copper bars and wire harnesses in the existing power distribution apparatus 1, the layout of electrical connections in the power distribution apparatus 1 can be further simplified, thereby further reducing the volume of the power distribution apparatus 1, improving the space utilization of the power distribution apparatus 1, and reducing the weight and costs of the power distribution apparatus 1, so as to further save the space of the battery pack 2, improve the energy density of the battery pack 2 and improve the battery endurance of the entire vehicle.

According to some specific embodiments of the present disclosure, as shown in FIG. 1, FIG. 2, and FIG. 4, the high-voltage loop 200 further includes a circuit protector 240, the circuit protector 240 is arranged on the base 100, and a first terminal of the circuit protector 240 forms a module positive-electrode connection end 210. The circuit protector 240 may include but is not limited to one or more loop protection devices such as fuses, circuit breakers, fuses, and active fuses. By setting the circuit protector 240, when the high-voltage loop 200 has an excessive current or voltage, the circuit protector 240 can automatically disconnect to cut off the high-voltage loop 200 in time, thereby protecting other components in the high-voltage loop 200.

In addition, there are a plurality of main disconnecting switch cores 230, and the plurality of main disconnecting switch cores include at least a main positive disconnecting switch core 231 and a main negative disconnecting switch core 232. A second terminal of the circuit protector 240 is electrically connected to a first terminal of the main positive disconnecting switch core 231, and a second terminal of the main positive disconnecting switch core 231 and a first terminal of the main negative disconnecting switch core 232 are respectively electrically connected to the high-voltage connection part 110.

The main positive disconnecting switch core 231 can include but is not limited to one or more of a core of a relay (that is, the relay does not need to be equipped with a housing), a core of an IGBT (that is, the IGBT does not need to be equipped with a housing), and a core of a MOS transistor (that is, the MOS transistor does not need to be equipped with a housing), and the main negative disconnecting switch core 232 can include but is not limited to one or more of a core of a relay (that is, the relay does not need to be equipped with a housing), a core of an IGBT (that is, the IGBT does not need to be equipped with a housing), and a core of a MOS transistor (that is, the MOS transistor do not need to be equipped with a housing).

It should be noted that the circuit board 300 is integrated with the low-voltage loop 400, so that connection and disconnection of the main positive disconnecting switch core 231 and connection and disconnection of the main negative disconnecting switch core 232 can be controlled.

For example, the main positive disconnecting switch core 231 can control whether the high-voltage connection part 110 and the module positive-electrode connection end 210 are connected, and the main negative disconnecting switch core 232 can control whether the high-voltage connection part 110 and the module negative-electrode connection end 220 are connected. When both the main positive disconnecting switch core 231 and the main negative disconnecting switch core 232 remain connected, the electrical conduction of the high-voltage loop 200 can be achieved. In this case, the battery module 700 can supply power to high-voltage electrical devices of the vehicle through the high-voltage connection part 110. Since the voltage of the current in the high-voltage loop 200 is relatively high, the main positive disconnecting switch core 231 and the main negative disconnecting switch core 232 are arranged, and connection and disconnection of the main positive disconnecting switch core 231 and the main negative disconnecting switch core 232 do not interfere with each other, so that the high-voltage loop 200 can be disconnected very reliably, to improve the safety of the high-voltage loop 200, thereby ensuring the safety of power supply to high-voltage electrical devices of the vehicle.

In addition, the plurality of high-and-low-voltage tabs 500 include a main positive low-voltage positive-electrode tab 510, a main positive low-voltage negative-electrode tab 520, a main negative low-voltage positive-electrode tab 530, and a main negative low-voltage negative-electrode tab 540, a first end of the main positive low-voltage positive-electrode tab 510 and a first end of the main positive low-voltage negative-electrode tab 520 are respectively connected to the main positive disconnecting switch core 231, a second end of the main positive low-voltage positive-electrode tab 510 and a second end of the main positive low-voltage negative-electrode tab 520 are respectively plugged into the circuit board 300 and are electrically connected to the low-voltage loop 400, a first end of the main negative low-voltage positive-electrode tab 530 and a first end of the main negative low-voltage negative-electrode tab 540 are respectively connected to the main negative disconnecting switch core 232, and a second end of the main negative low-voltage positive-electrode tab 530 and a second end of the main negative low-voltage negative-electrode tab 540 are respectively plugged into the circuit board 300 for electrical connection with the low-voltage loop 400.

In this way, the main positive disconnecting switch core 231 achieves electrical connection with the low-voltage loop 400 on the circuit board 300 through the main positive low-voltage positive-electrode tab 510 and the main positive low-voltage negative-electrode tab 520, and the main negative disconnecting switch core 232 achieves electrical connection with the low-voltage loop 400 on the circuit board 300 through the main negative low-voltage positive-electrode tab 530 and the main negative low-voltage negative-electrode tab 540, so that the low-voltage loop 400 on the circuit board 300 can be used to control connection and disconnection of the main positive disconnecting switch core 231 and connection and disconnection of the main negative disconnecting switch core 232.

Moreover, the main positive disconnecting switch core 231 is directly connected to the circuit board 300 in a plugging manner through the main positive low-voltage positive-electrode tab 510 and the main positive low-voltage negative-electrode tab 520, which can eliminate a conductive structure (for example, a conductive copper bar or wire) between the main positive disconnecting switch core 231 and the circuit board 300, to ensure reliable electrical connection between the main positive disconnecting switch core 231 and the circuit board 300, and help to reduce the volume, costs and weight of the power distribution apparatus 1. Meanwhile, the main negative disconnecting switch core 232 is directly connected to the circuit board 300 in a plugging manner through the main negative low-voltage positive-electrode tab 530 and the main negative low-voltage negative-electrode tab 540, which can eliminate a conductive structure (for example, a conductive copper bar or wire) between the main negative disconnecting switch core 232 and the circuit board 300, to ensure reliable electrical connection between the main negative disconnecting switch core 232 and the circuit board 300, and help to reduce the volume, costs and weight of the power distribution apparatus 1.

Optionally, as shown in FIG. 1, FIG. 2 and FIG. 4, a second terminal of the circuit protector 240 is electrically connected to a first terminal of the main positive disconnecting switch core 231 through overlapping, and a second terminal of the main positive disconnecting switch core 231 and a first terminal of the main negative disconnecting switch core 232 are respectively electrically connected to the high-voltage connection part 110 through overlapping.

In this way, there is no need to arrange a conductive structure (for example, a conductive copper bar) between the circuit protector 240 and the main disconnecting switch core 230, and the power distribution apparatus 1 has higher space utilization, and therefore has a smaller size, a lighter weight and lower costs. Therefore, it is conducive to improving reliability of the electrical connection between the circuit protector 240 and the main disconnecting switch core 230, and it is not prone to problems such as excessive temperature rise and sintering at the connection point. There is no need to arrange a conductive structure (for example, a conductive copper bar or wire) between the main positive disconnecting switch core 231 and the high-voltage connection part 110 and between the main negative disconnecting switch core 232 and the high-voltage connection part. This simplifies the electrical connection structure of the main positive disconnecting switch core 231 and the main negative disconnecting switch core 232, the electrical connection is reliable, the layout is simple, and it is not prone to problems such as excessive temperature rise or sintering at the connection point.

Further, as shown in FIG. 1, FIG. 2, and FIG. 4, the plurality of high-and-low-voltage tabs 500 further include a positive-electrode voltage collection piece 550 and a negative-electrode voltage collection piece 560. A first end of the positive-electrode voltage collection piece 550 is overlapped at an overlapping position between the second terminal of the main positive disconnecting switch core 231 and the high-voltage connection part 110, and a second end of the positive-electrode voltage collection piece 550 is plugged into the circuit board 300 and is electrically connected to the low-voltage loop 400. A first end of the negative-electrode voltage collection piece 560 is overlapped at an overlapping position between the first terminal of the main negative disconnecting switch core 232 and the high-voltage connection part 110, and a second end of the negative-electrode voltage collection piece 560 is plugged into the circuit board 300 and is electrically connected to the low-voltage loop 400.

In this way, the circuit board 300 can collect the voltage of the high-voltage loop 200 through the positive-electrode voltage collection piece 550 and the negative voltage collection piece 560, to monitor the voltage of the high-voltage loop 200 and whether sintering occurs, which is conducive to the reliable application of the power distribution apparatus 1 and improves the safety of the power distribution apparatus 1.

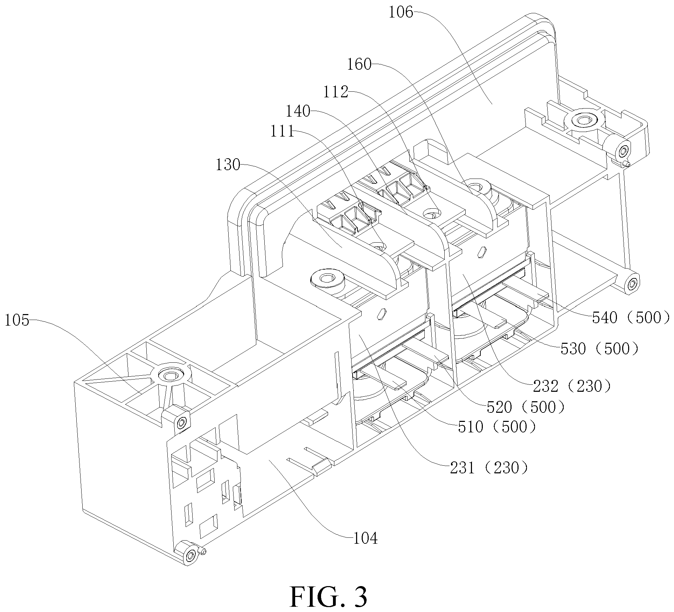

Furthermore, as shown in FIG. 3 to FIG. 6, the high-voltage connection part 110 includes a high-voltage positive-electrode lead-out piece 111 and a high-voltage negative-electrode lead-out piece 112. The high-voltage positive-electrode lead-out piece 111 overlaps with the second terminal of the main positive disconnecting switch core 231 and an end of the positive-electrode voltage collection piece 550 for electrical connection. In this way, there is no need to arrange a conductive structure (for example, a conductive copper bar or wire) between the high-voltage positive-electrode lead-out piece 111 and the main positive disconnecting switch core 231, and there is no need to arrange a conductive structure (for example, a conductive copper bar or wire) between the high-voltage positive-electrode lead-out piece 111 and the positive-electrode voltage collection piece 550. The high-voltage negative-electrode lead-out piece 112 overlaps with the first terminal of the main negative disconnecting switch core 232 and an end of the negative-electrode voltage collection piece 560 for electrical connection. In this way, there is no need to arrange a conductive structure (for example, a conductive copper bar or wire) between the high-voltage negative-electrode lead-out piece 112 and the main negative disconnecting switch core 232, and there is no need to arrange a conductive structure (for example, a conductive copper bar or wire) between the high-voltage negative-electrode lead-out piece 112 and the negative-electrode voltage collection piece 560.

By arranging the high-voltage positive-electrode lead-out piece 111 and the high-voltage negative-electrode lead-out piece 112, the electrical connection between the high-voltage connection part 110 and the high-voltage loop 200 can be achieved to ensure that the high-voltage connection part 110 can supply power to high-voltage electrical components of the vehicle. In addition, this can further simplify the layout of electrical connection within the power distribution apparatus 1, thereby further reducing the volume of the power distribution apparatus 1 and improving the space utilization of the power distribution apparatus 1, and reducing the weight and costs of the power distribution apparatus 1, so as to further save the space of the battery pack 2, improve the energy density of the battery pack 2, and improve battery endurance of the entire vehicle.

In some embodiments of the present disclosure, the second terminal of the main positive disconnecting switch core 231, the high-voltage positive-electrode lead-out piece 111, and the end of the positive-electrode voltage collection piece 550 overlap with each other in sequence, one of the high-voltage positive-electrode lead-out piece 111 and the positive-electrode voltage collection piece 550 is provided with a positive-electrode anti-rotation positioning groove, and the other of the high-voltage positive-electrode lead-out piece 111 and the positive-electrode voltage collection piece 550 mates with the positive-electrode anti-rotation positioning groove. The first terminal of the main negative disconnecting switch core 232, the high-voltage negative-electrode lead-out piece 112, and the end of the negative-electrode voltage collection piece 560 overlap with each other in sequence, one of the high-voltage negative-electrode lead-out piece 112 and the negative-electrode voltage collection piece 560 is provided with a negative-electrode anti-rotation positioning groove, and the other of the high-voltage negative-electrode lead-out piece 112 and the negative-electrode voltage collection piece 560 mates with the negative-electrode anti-rotation positioning groove.

For example, the positive-electrode anti-rotation positioning groove can be arranged on the high-voltage positive-electrode lead-out piece 111, the negative-electrode anti-rotation positioning groove can be arranged on the high-voltage negative-electrode lead-out piece 112 to reduce the probability of damage to the positive-electrode voltage collection piece 550 and the negative-electrode voltage collection piece 560, ensuring the reliability of voltage collection.

On the one hand, this can prevent the positive-electrode voltage collection piece 550 and the negative-electrode voltage collection piece 560 from being translated in the width direction of the base 100, thereby improving the stability of the electrical connection and increasing the accuracy of voltage collection. On the other hand, this can prevent the positive-electrode voltage collection piece 550 and the negative-electrode voltage collection piece 560 from rotating during the assembly process, especially in embodiments where the positive-electrode voltage collection piece 550 and the negative-electrode voltage collection piece 560 need to be installed and fixed through threaded fasteners (for example, bolts).

Further, as shown in FIG. 1 to FIG. 6, the base 100 is configured with a first positioning separation rib 130 and a second positioning separation rib 140. The first positioning separation rib 130 is located between the circuit protector 240 and the high-voltage positive-electrode lead-out piece 111 and between the circuit protector 240 and the positive-electrode voltage collection piece 550, and the second positioning separation rib 140 is located between the high-voltage positive-electrode lead-out piece 111 and the high-voltage negative-electrode lead-out piece 112 and between the positive-electrode voltage collection piece 550 and the negative-electrode voltage collection piece 560.

The first positioning separation rib 130 can separate the positive-electrode voltage collection piece 550 from the negative-electrode voltage collection piece 560 to avoid incorrect electrical connection between the circuit protector 240 and the high-voltage positive-electrode lead-out piece 111 caused by movement, can separate the circuit protector 240 from the positive-electrode voltage collection piece 550 to avoid incorrect electrical connection between the circuit protector 240 and the positive-electrode voltage collection piece 550 caused by movement, and can also position the circuit protector 240, the high-voltage positive-electrode lead-out piece 111 and the positive-electrode voltage collection piece 550 to some extent.

The second positioning separation rib 140 can separate the high-voltage positive-electrode lead-out piece 111 from the high-voltage negative-electrode lead-out piece 112 to avoid incorrect electrical connection between the high-voltage positive-electrode lead-out piece 111 and the high-voltage negative-electrode lead-out piece 112 caused by movement, can separate the positive-electrode voltage collection piece 550 from the negative-electrode voltage collection piece 560 to avoid incorrect electrical connection between the positive-electrode voltage collection piece 550 and the negative-electrode voltage collection piece 560 caused by movement, and can also position the high-voltage positive-electrode lead-out piece 111, the high-voltage negative-electrode lead-out piece 112, the positive-electrode voltage collection piece 550, and the negative-electrode voltage collection piece 560 to some extent.

In some specific embodiments of the present disclosure, as shown in FIG. 1 to FIG. 4, the high-voltage loop 200 further includes a current sensor 150, a first terminal of the current sensor 150 forms the module negative-electrode connection end 220, and a second terminal of the current sensor 150 is electrically connected to the second terminal of the main negative disconnecting switch core 232. The plurality of high-and-low-voltage tabs 500 further include a current collection pin 570. A first end of the current collection pin 570 is connected to the current sensor 150. A second end of the current collection pin 570 is plugged into the circuit board 300 and is electrically connected to the low-voltage loop 400. In this way, the copper bar or wire harness between the current collection pin 570 and the circuit board 300 and between the current collection pin and the low-voltage loop 400 can be eliminated, and at the same time, the electrical connection between the current collection pin 570 and the circuit board 300 and between the current collection pin and the low-voltage loop 400 can be implemented, thereby saving space in the power distribution apparatus 1 and improving the safety of electrical connection. The current sensor 150 can be used as a high voltage supervise unit (High voltage supervise unit, HVSU).

By setting the current sensor 150, the module negative-electrode connection end 220 can be formed to achieve an effective connection between the high-voltage loop 200 and the battery module 700. In addition, the circuit board 300 can obtain, through the current collection pin 570, the current of the high-voltage loop 200 collected by the current sensor 150, thereby ensuring the stability of the current of the high-voltage loop 200, which is conducive to the reliable usage of the power distribution apparatus 1. The current sensor 150 can be a shunt.

Furthermore, the second terminal of the current sensor 150 overlaps with the second terminal of the main negative disconnecting switch core 232 for electrical connection. There is no need to arrange a conductive structure (for example, a conductive copper bar or wire) between the current sensor 150 and the main negative disconnecting switch core 232, thereby not only reducing the risk of sintering and excessive temperature rise between the current sensor 150 and the main negative disconnecting switch core 232, but also improving the space utilization of the power distribution apparatus 1 and reducing the volume of the power distribution apparatus 1 and the weight and costs of the power distribution apparatus 1.

Furthermore, as shown in FIG. 1 to FIG. 6, the base 100 is configured with a third positioning separation rib 160, and the third positioning separation rib 160 is located between the current sensor 150 and the high-voltage connection part 110.

The third positioning separation rib 160 not only can separate the current sensor 150 from the high-voltage connection part 110 to avoid incorrect electrical connection between the current sensor 150 and the high-voltage connection part 110 caused by movement, but also can position the current sensor 150 and the high-voltage connection part 110 to some extent.

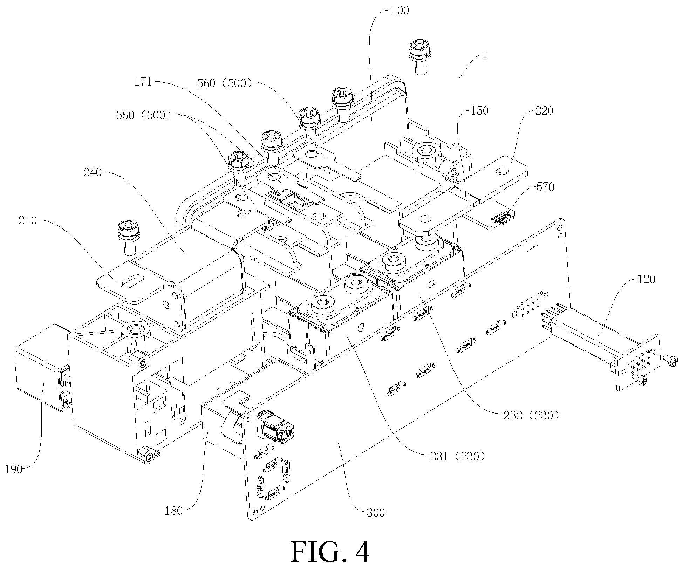

Optionally, as shown in FIG. 1 and FIG. 4, the circuit protector 240, the main positive disconnecting switch core 231, the main negative disconnecting switch core 232 and the current sensor 150 are arranged in sequence along the length direction of the base 100, which facilitates overlapping between a plurality of components in the high-voltage loop 200 and is conducive to eliminating a conductive structure (for example, a conductive copper bar or wire), thereby improving the space utilization of the power distribution apparatus 1 and reducing the volume and costs and weight of the power distribution apparatus 1, ensuring the reliability of the electrical connection, and avoiding damage to the high-voltage loop 200. Moreover, because the high-voltage loop 200 is mainly arranged along the length direction of the base 100, the space of the base 100 can be used more effectively.

Moreover, the low-voltage connection part 120 and the current sensor 150 are arranged along the width direction of the base 100, so that the low-voltage connection part 120 and the current sensor 150 do not need to continue to be arranged along the length of the base 100, which can reduce the length of the power distribution apparatus 1, further improve the space utilization of the power distribution apparatus 1, and reduce the weight and costs of the power distribution apparatus 1.

According to some specific embodiments of the present disclosure, as shown in FIG. 1, FIG. 2, FIG. 4 and FIG. 7, the high-voltage loop 200 further includes a precharge loop 170, a portion of the precharge loop 170 is integrated into the circuit board 300, and the precharge loop 170 includes a precharge resistor 180 and a precharge disconnecting switch 190. The precharge resistor 180 and the precharge disconnecting switch 190 are arranged on the base 100 and plugged into the circuit board 300. The precharge resistor 180 and the precharge disconnecting switch 190 are connected in series to each other and are connected in parallel with the main disconnecting switch core 230.

The precharge resistor 180 and the precharge disconnecting switch 190 are connected in series to each other, and after the precharge resistor 180 and the precharge disconnecting switch 190 are connected in series to each other, the precharge resistor and the precharge disconnecting switch are connected in parallel to the main disconnecting switch core 230. Moreover, the precharge disconnecting switch 190 and the low-voltage loop 400 are directly connected to each other, that is, there is no need to arrange a transformer structure between the precharge disconnecting switch 190 and the low-voltage loop 400.

By setting up the precharge loop 170, the battery module 700 and the main disconnecting switch core 230 can be prevented from being damaged, thus ensuring safety of the battery module 700 and the main disconnecting switch core 230. The circuit board 300 can control connection and disconnection of the precharge disconnecting switch 190. Moreover, the precharge disconnecting switch 190 can be directly fixed on the base 100. There is no need to arrange an additional housing for the precharge disconnecting switch 190, which can reduce the volume of the power distribution apparatus 1 and the weight and costs of the power distribution apparatus 1.

In addition, the precharge resistor 180 and the precharge disconnecting switch 190 are both plugged into the circuit board 300, and there is no need to arrange a conductive structure (for example, a conductive copper bars or wire) between the precharge resistor and the circuit board 300 and between the precharge disconnecting switch and the circuit board, which can simplify the layout of the power distribution apparatus 1, reduce the volume of the power distribution apparatus 1, and improve space utilization of the power distribution apparatus 1.

The precharge resistor 180 can be a thermistor. As the thermistor is applied to the precharge loop 170, the precharge loop 170 has a simple structure, a small volume, is easy to integrate with other components, has protection capabilities against precharge overheating, and has good adaptability to the working environments and resistance ranges.

For example, the resistance of a thermistor is relatively sensitive to temperature. When the temperature of the thermistor rises above a temperature conversion point (a Curie temperature point), the resistance rises sharply. When the thermistor is applied to the precharge loop 170, only a resistance range for normal working (between the minimum resistance and the resistance corresponding to the Curie temperature) needs to be considered. The resistance range and the allowable energy range of the thermistor can be calculated based on parameter requirements such as a voltage, a load capacitance, a precharge completion voltage difference, and a precharge time.

The minimum resistance of the thermistor is calculated as follows: Rmin≥tmin/(C*ln(UB/UB-Ut)), and the maximum resistance of the thermistor is calculated as follows: Rmax≤tmax/(C*ln(UB/UB-Ut)). tmin is the minimum precharge time, tmax is the maximum precharge time, Rmin is the minimum resistance of the thermistor, Rmax is the maximum resistance of the thermistor, C is a capacitance of a capacitive load, Ut is a corresponding terminal voltage of a capacitive load during the precharge process, and UB is a voltage of the battery module 700.

After calculating the resistance range of the thermistor, precharge time verification is performed according to a temperature-resistance property curve of the selected thermistor. Within a temperature range, such as - 60°C to 130°C, the maximum and minimum values of corresponding resistances of the thermistor within this temperature range are selected for precharge time verification.

During the precharge process of the thermistor, the maximum energy released by the precharge loop 170 to the thermistor is calculated as follows: Ech=½CU². Energy that needs to be absorbed when the temperature of a single thermistor rises from the maximum operating environment temperature Tamax to the Curie temperature Tc is Eth: Eth=Cth*(Tc-Tamax), where Cth is the heat capacity (that is, energy required to increase the temperature of the thermistor body by 1K, and the unit is joule) of the thermistor.

The thermistor should maintain a low resistance state during normal usage; otherwise, the charging time is affected. If the energy of the charging loop is greater than allowable energy of a single thermistor, a plurality of thermistors can be connected in series or in parallel for energy decomposition, to increase the circuit voltage resistance and energy tolerance capability, that is, n*§*Eth≥Ech. § is a reserve margin for safety that is generally 0.7 to 0.9, and n is a number of thermistors used. The number of thermistors obtained through this calculation method not only meets the requirements, but also can reduce costs.

**In** some embodiments of the present disclosure, a resistance range of a single thermistor can be 20Ω to 200Ω, an ambient temperature range is -60°C to 130°C, and a single withstand voltage capability can be a withstand voltage 450VDC and below or a withstand voltage 1000VDC and below.

The following uses an example in which when the voltage is 400VDC, the capacitance value of the capacitive load is 800µf, and the charging voltage difference is 98%, a response time is within 1.5 seconds. Parameters of a single thermistor are as follows: a resistance value is 70 Ω, a withstand voltage is 500VDC, a Curie temperature is 125 °C, a resistance range of the thermistor is 56 Ω to 112 Ω within the range of -60 °C to 125 °C, and thermal capacity is 2.5J/K. The number of used thermistors can be preliminarily selected as follows:

| Voltage/capacitance | 800µF or less (including 800) | 1500µF (800 to 1500) | 2500µF (1500 to 2500) |
|---|---|---|---|
| 500VDC | one thermistor | two thermistors in parallel | three thermistors in parallel |
| 1000VDC | two thermistors in series | two thermistors in parallel and two thermistors in series | three thermistors in parallel and two thermistors in series |

Verification is performed based on the above formula. Precharge is completed within 180ms to 360ms, the safety margin can be selected as 0.8, the maximum ambient temperature is 90°C, the energy required for the thermistor to reach the Curie temperature is 70J, and the circuit energy is 64J, that is, a single thermistor meets the requirement and meets the expected condition.

The above is only an explanation of a certain embodiment of the present disclosure, and is intended to further illustrate the practical application, and is not intended to limit the patent scope of the present disclosure.

In addition, the plurality of high-and-low-voltage tabs 500 further include a precharge low-voltage positive-electrode tab 580 and a precharge low-voltage negative-electrode tab 590, a first end of the precharge low-voltage positive-electrode tab 580 and a first end of the precharge low-voltage negative-electrode tab 590 are respectively connected to the precharge disconnecting switch 190, and a second end of the precharge low-voltage positive-electrode tab 580 and a second end of the precharge low-voltage negative-electrode tab 590 are respectively plugged into the circuit board 300 for electrical connection with the low-voltage loop 400.

In this way, the electrical connection between the precharge disconnecting switch 190 and the low-voltage loop 400 on the circuit board 300 can be implemented, so that the low-voltage loop 400 can control connection and disconnection of the precharge disconnecting switch 190. Besides, intermediate connectors such as conductive wires and copper bars between the precharge disconnecting switch 190 and the circuit board 300 can be eliminated, and the layout of electrical connection in the power distribution apparatus 1 can be further simplified, thereby further reducing the volume of the power distribution apparatus 1, increasing the space utilization of the power distribution apparatus 1, and reducing the weight and costs of the power distribution apparatus 1.

In some embodiments of the present disclosure, as shown in FIG. 2, the precharge disconnecting switch 190 has a precharge high-voltage positive-electrode tab 191 and a precharge high-voltage negative-electrode tab 192. The precharge resistor 180 has a resistor high-voltage tab 181. The circuit protector 240 and the precharge resistor 180 are electrically connected through contact. In this way, conductive structures such as copper bars and wire harnesses between the precharge disconnecting switch 190 and the precharge resistor 180 can be eliminated. The precharge high-voltage positive-electrode tab191, the precharge high-voltage negative-electrode tab 192 and the resistor high-voltage tab 181 are plugged into the circuit board 300 for electrical connection with a portion of the precharge loop 170 integrated on the circuit board 300, thus eliminating existing intermediate connectors between the precharge disconnecting switch 190 and the circuit board 300 and between the precharge resistor 180 and the circuit board, that is, the copper bars and wire harnesses of the precharge part.

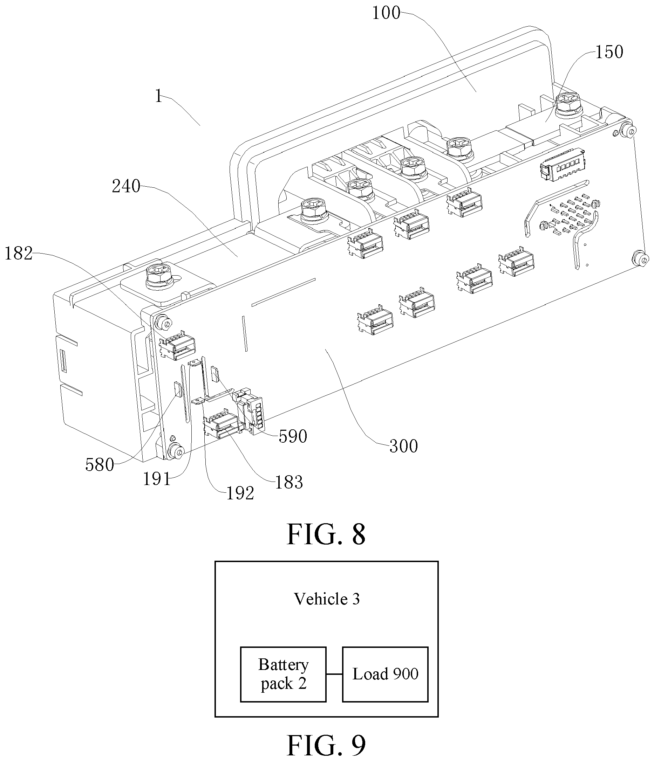

In some other embodiments of the present disclosure, as shown in FIG. 8, the precharge disconnecting switch 190 has a precharge high-voltage positive-electrode tab 191 and a precharge high-voltage negative-electrode tab 192, the precharge resistor 180 has a resistor high-voltage positive-electrode tab 182 and a resistor high-voltage negative-electrode tab 183, and the precharge high-voltage positive-electrode tab 191, the precharge high-voltage negative-electrode tab 192, the resistor high-voltage positive-electrode tab 182 and the resistor high-voltage negative-electrode tab 183 are plugged into the circuit board 300 for electrical connection with a portion of the precharge loop 170 integrated on the circuit board 300. In this case, there is no need to connect the precharge resistor180 to the circuit protector 240, and the precharge resistor 180 only needs to be connected to the circuit board 300, which is easy to disassemble and assemble and easy to process.

Therefore, the electrical connection between the precharge disconnecting switch 190 and the circuit board 300 and between the precharge resistor 180 and the circuit board is more reliable, the layout is clear, and it is not prone to problems such as excessive temperature rise or sintering at the connection point. By eliminating a large number of copper bars and wire harnesses in the existing power distribution apparatus 1, the layout of electrical connections in the power distribution apparatus 1 can be further simplified, thereby further reducing the volume of the power distribution apparatus 1, improving the space utilization of the power distribution apparatus 1, and reducing the weight and costs of the power distribution apparatus 1, so as to further save the space of the battery pack 2, improve the energy density of the battery pack 2 and improve the battery endurance of the entire vehicle.

Optionally, as shown in FIG. 2, the precharge loop 170 also includes a precharge tab 171, a second terminal of the circuit protector 240 is electrically connected to a first terminal of the main positive disconnecting switch core 231 through overlapping, a first end of the precharge tab 171 is overlapped at an overlapping position between the second terminal of the circuit protector 240 and the first terminal of the main positive disconnecting switch core 231, and a second end of the precharge tab 171 is plugged into the circuit board 300 and electrically connected to a portion of the precharge loop 170 integrated on the circuit board 300.

By setting the precharge tab 171, the parallel connection between the precharge loop 170 and the main positive disconnecting switch core 230 can be achieved, and the precharge tab can be used to detect the voltage of the precharge loop 170. Besides, the precharge tab 171 adopts an electrical plugging method to achieve electrical connection, and there is no need to arrange a conductive structure (for example, a conductive copper bar or wire) between the precharge tab 171 and the circuit board 300, and there is no need to arrange a conductive structure (for example, a conductive copper bar or wire) between the precharge tab 171 and the overlapping position between the second terminal of the circuit protector 240 and the first terminal of the main positive disconnecting switch core 231, which can simplify the layout of the power distribution apparatus 1, reduce the volume of the power distribution apparatus 1, and improve the space utilization of the power distribution apparatus 1.

The precharge tab 171 is integrally formed with the second terminal of the circuit protector 240. In this way, the connection strength between the precharge tab 171 and the circuit protector 240 is high, which can ensure the reliability of the electrical connection between the precharge tab 171 and the circuit protector 240.

In some optional embodiments of the present disclosure, as shown in FIG. 2 and FIG. 4, the precharge disconnecting switch 190, the precharge resistor 180, the main positive disconnecting switch core 231, the main negative disconnecting switch core 232 and the low-voltage connection part 120 are arranged in sequence along the length direction of the base 100. This further improves the space utilization of the base 100 and ensures reliable circuit connection of the power distribution apparatus 1. In addition, the precharge disconnecting switch 190, the precharge resistor 180 and the circuit protector 240 are arranged along the width direction of the base 100, so that any two of the precharge disconnecting switch 190, the precharge resistor 180 and the circuit protector 240 are staggered in the length direction of the base 100, which can reduce the length of the base 100 to a certain extent, thereby reducing the volume of the power distribution apparatus 1.

In some optional embodiments of the present disclosure, as shown in FIG. 2, FIG. 5 and FIG. 6, the base 100 is configured with a main positive disconnecting switch core installation groove 101, a main negative disconnecting switch core installation groove 102, a precharge disconnecting switch installation groove 103 and a precharge resistor installation groove 104. The main positive disconnecting switch core 231 is fixed to the main positive disconnecting switch core installation groove 101 through thermal conductive potting of glue; the main negative disconnecting switch core 232 is fixed to the main negative disconnecting switch core installation groove 102 through thermal conductive potting of glue; the precharge disconnecting switch 190 is clamped in the precharge disconnecting switch installation groove 103 or fixed to the precharge disconnecting switch installation groove 103 through thermal conductive potting of glue; and the precharge resistor 180 is clamped in the precharge resistor installation groove 104.

In this way, the connection strength between the base 100 and each of the main positive disconnecting switch core 231, the main negative disconnecting switch core 232, the precharge disconnecting switch 190 and the precharge resistor 180 is higher, which can prevent the main positive disconnecting switch core 231, the main negative disconnecting switch core 232, the precharge disconnecting switch 190, and the precharge resistor 180 from moving relative to the base 100, thereby improving the reliability of the electrical connection in the power distribution apparatus 1.

**In** some optional embodiments of the present disclosure, as shown in FIG. 2 to FIG. 6, the base 100 includes a base body 105 and a panel 106, where both the base body 105 and the panel 106 can be insulating parts, for example, made of a plastic material. At least a portion of the high-voltage loop 200 is arranged on the base body 105, the circuit board 300 is arranged on the base body 105, the panel 106 is connected to the base 105, and the high-voltage connection part 110 and the low-voltage connection part 120 are fixed on the panel 106. This can ensure the structural strength of the base 105, and ensure the stable arrangement of the high-voltage loop 200 and the circuit board 300. In addition, the base 100 is divided into two parts, which not only facilitates the processing and manufacturing of the base body 105 and the panel 106, but also facilitates arrangement of the high-voltage loop 200, the circuit board 300 and the low-voltage loop on the base 100.

Optionally, the base body105 and the panel 106 are one piece or separate pieces. It should be noted that when the base body 105 and the panel106 are one piece, the base body 105 and the panel 106 can be manufactured separately first. Then, the base body 105 and the panel 106 are formed into one piece to facilitate arrangement of the high-voltage loop 200, the circuit board 300 and the low-voltage loop 400. Alternatively, the base body 105 and the panel 106 are directly injection molded once to improve the connection strength between the base body 105 and the panel 106. In this way, the setting methods of the base 100 are more diverse, so that the structure of the base 100 can be adjusted according to different usage situations, the applicability of the base 100 can be improved, and the power distribution apparatus 1 can meet the needs of different usage environments.

An assembly process of the power distribution apparatus 1 according to the embodiments of the present disclosure is described below with reference to examples.

First, potting of glue is used to fix the main positive disconnecting switch core 231 and the main negative disconnecting switch core 232 in the main positive disconnecting switch core installation groove 101 and the main negative disconnecting switch core installation groove 102 of the base 100 respectively.

Then, the precharge resistor 180 and the precharge disconnecting switch 190 are clamped in the precharge resistor installation groove 104 and the precharge disconnecting switch installation groove 103 of the base 100.

Next, the circuit protector 240 is placed on the base 100 and is electrically connected to the precharge resistor 180 through buckling, bolts are used to fix the positive-electrode voltage collection piece 550, the negative-electrode voltage collection piece 560 and the current sensor 150. The circuit board 300 is fixed on the base 100. At the same time, the tabs are aligned and plugged (for example, a main positive low-voltage positive-electrode tab 510, a main positive low-voltage negative-electrode tab 520, a main negative low-voltage positive-electrode tab 530, a main negative low-voltage negative-electrode tab 540, a positive-electrode voltage collection piece 550, a negative-electrode voltage collection piece 560, a current collection pin 570, and a precharge tab 171), and the low-voltage connection part 120 on the circuit board 300 is inserted into a hole reserved on the base 100.

Finally, the base 100 is sealed.

A vehicle 3 according to the embodiments of the present disclosure is described below with reference to FIG. 9, and includes the battery pack 2 according to the embodiments of the present disclosure.

In the vehicle according to this embodiment of the present disclosure, the battery pack 2 in the embodiments of the present disclosure is used, which has advantages such as a simple and compact structure, high space utilization, a small size, a light weight, and low costs.

In some optional embodiments of the present disclosure, the vehicle further includes a load 900 electrically connected to the battery pack. This battery pack is configured to supply power to the load. The load includes an electrical component of the vehicle, for example, a motor, an air conditioning compressor, a PTC (Positive Temperature Coefficient), or a controller.

Other configurations and operations of the power distribution apparatus 1, the battery pack 2, and the vehicle 3 according to the embodiments of the present disclosure are known to those of ordinary skill in the art and will not be described in detail herein.

In the description of this specification, description of reference terms such as "a specific embodiment" or "a specific example", means including specific features, structures, materials, or features described in the embodiment or example in at least one embodiment or example of the present disclosure. In this specification, exemplary descriptions of the foregoing terms do not necessarily refer to the same embodiment or example.

Although embodiments of the present disclosure have been shown and described, those with ordinary skill in the art may understand that various changes, modifications, substitutions, and variations can be made to these embodiments without departing from the principles and purposes of the present disclosure, and the scope of the present disclosure is limited by the claims and their equivalents.

## Claims

1. A power distribution apparatus (1), comprising:
a base (100), a high-voltage connection part (110) and a low-voltage connection part (120) being fixed on the base;
a high-voltage loop (200), at least a portion of the high-voltage loop being arranged on the base, the high-voltage loop being electrically connected to the high-voltage connection part, the high-voltage loop having a module positive-electrode connection end (210) and a module negative-electrode connection end (220), and the high-voltage loop comprising a main disconnecting switch core (230) fixed on the base;
a circuit board (300), the circuit board being arranged on the base;
a low-voltage loop (400), the low-voltage loop being integrated into the circuit board and being electrically connected to the low-voltage connection part; and
a plurality of high-and-low-voltage tabs (500), a first end of each high-and-low-voltage tab being connected to the high-voltage loop for electrical connection, and a second end of the high-and-low-voltage tab being plugged into the circuit board for electrical connection with the low-voltage loop.

2. The power distribution apparatus according to claim 1, wherein the plurality of high-and-low-voltage tabs are parallel to each other and perpendicular to the circuit board.

3. The power distribution apparatus according to claim 1, wherein the high-voltage loop overlap with the high-voltage connection part for electrical connection;
the low-voltage connection part is plugged into the circuit board for electrical connection with the low-voltage loop; and
components connected in the high-voltage loop overlap with each other for electrical connection.

4. The power distribution apparatus according to claim 1, wherein the high-voltage loop further comprises a circuit protector (240), the circuit protector is arranged on the base, and a first terminal of the circuit protector forms the module positive-electrode connection end;
the main disconnecting switch core comprises a plurality of main disconnecting switch cores, the plurality of main disconnecting switch cores comprise at least a main positive disconnecting switch core (231) and a main negative disconnecting switch core (232), a second terminal of the circuit protector is electrically connected to a first terminal of the main positive disconnecting switch core, and a second terminal of the main positive disconnecting switch core and a first terminal of the main negative disconnecting switch core are respectively electrically connected to the high-voltage connection part; and
the plurality of high-and-low-voltage tabs comprise a main positive low-voltage positive-electrode tab (510), a main positive low-voltage negative-electrode tab (520), a main negative low-voltage positive-electrode tab (530), and a main negative low-voltage negative-electrode tab (540), a first end of the main positive low-voltage positive-electrode tab and a first end of the main positive low-voltage negative-electrode tab are respectively connected to the main positive disconnecting switch core, a second end of the main positive low-voltage positive-electrode tab and a second end of the main positive low-voltage negative-electrode tab are respectively plugged into the circuit board and are electrically connected to the low-voltage loop, a first end of the main negative low-voltage positive-electrode tab and a first end of the main negative low-voltage negative-electrode tab are respectively connected to the main negative disconnecting switch core, and a second end of the main negative low-voltage positive-electrode tab and a second end of the main negative low-voltage negative-electrode tab are respectively plugged into the circuit board for electrical connection with the low-voltage loop.

5. The power distribution apparatus according to claim 4, wherein the second terminal of the circuit protector overlaps with the first terminal of the main positive disconnecting switch core for electrical connection; and
the second terminal of the main positive disconnecting switch core and the first terminal of the main negative disconnecting switch core respectively overlap with the high-voltage connection part for electrical connection.

6. The power distribution apparatus according to claim 5, wherein the plurality of high-and-low-voltage tabs further comprise:
a positive-electrode voltage collection piece (550), a first end of the positive-electrode voltage collection piece being overlapped at an overlapping position between the second terminal of the main positive disconnecting switch core and the high-voltage connection part, and a second end of the positive-electrode voltage collection piece being plugged into the circuit board and being electrically connected to the low-voltage loop; and
a negative-electrode voltage collection piece (560), a first end of the negative-electrode voltage collection piece being overlapped at an overlapping position between the first terminal of the main negative disconnecting switch core and the high-voltage connection part, and a second end of the negative-electrode voltage collection piece being plugged into the circuit board and being electrically connected to the low-voltage loop.

7. The power distribution apparatus according to claim 6, wherein the high-voltage connection part comprises:
a high-voltage positive-electrode lead-out piece (111), the high-voltage positive-electrode lead-out piece overlapping with the second terminal of the main positive disconnecting switch core and an end of the positive-electrode voltage collection piece for electrical connection; and
a high-voltage negative-electrode lead-out piece (112), the high-voltage negative-electrode lead-out piece overlapping with the first terminal of the main negative disconnecting switch core and an end of the negative-electrode voltage collection piece for electrical connection.

8. The power distribution apparatus according to claim 7, wherein the second terminal of the main positive disconnecting switch core, the high-voltage positive-electrode lead-out piece, and the end of the positive-electrode voltage collection piece overlap with each other in sequence, one of the high-voltage positive-electrode lead-out piece and the positive-electrode voltage collection piece is provided with a positive-electrode anti-rotation positioning groove, and the other of the high-voltage positive-electrode lead-out piece and the positive-electrode voltage collection piece mates with the positive-electrode anti-rotation positioning groove; and
the first terminal of the main negative disconnecting switch core, the high-voltage negative-electrode lead-out piece, and the end of the negative-electrode voltage collection piece overlap with each other in sequence, one of the high-voltage negative-electrode lead-out piece and the negative-electrode voltage collection piece is provided with a negative-electrode anti-rotation positioning groove, and the other of the high-voltage negative-electrode lead-out piece and the negative-electrode voltage collection piece mates with the negative-electrode anti-rotation positioning groove.

9. The power distribution apparatus according to claim 7, wherein the base is configured with a first positioning separation rib (130) and a second positioning separation rib (140);
the first positioning separation rib is located between the circuit protector and the high-voltage positive-electrode lead-out piece and between the circuit protector and the positive-electrode voltage collection piece; and
the second positioning separation rib is located between the high-voltage positive-electrode lead-out piece and the high-voltage negative-electrode lead-out piece and between the positive-electrode voltage collection piece and the negative-electrode voltage collection piece.

10. The power distribution apparatus according to claim 4, wherein the high-voltage loop further comprises a current sensor (150), a first terminal of the current sensor forming the module negative-electrode connection end, and a second terminal of the current sensor being electrically connected to the second terminal of the main negative disconnecting switch core; and
the plurality of high-and-low-voltage tabs further comprise a current collection pin (570), a first end of the current collection pin is connected to the current sensor, and a second end of the current collection pin is plugged into the circuit board and is electrically connected to the low-voltage loop.

11. The power distribution apparatus according to claim 10, wherein the second terminal of the current sensor overlaps with the second terminal of the main negative disconnecting switch core for electrical connection.

12. The power distribution apparatus according to claim 10, wherein the base is configured with a third positioning separation rib (160), and the third positioning separation rib is located between the current sensor and the high-voltage connection part.

13. The power distribution apparatus according to claim 10, wherein the circuit protector, the main positive disconnecting switch core, the main negative disconnecting switch core, and the current sensor are arranged in sequence along a length direction of the base; and
the low-voltage connection part and the current sensor are arranged along a width direction of the base.

14. The power distribution apparatus according to claim 4, wherein the high-voltage loop further comprises a precharge loop (170), a portion of the precharge loop is integrated into the circuit board, the precharge loop comprises a precharge resistor (180) and a precharge disconnecting switch (190), the precharge resistor and the precharge disconnecting switch are arranged on the base and plugged into the circuit board, and the precharge resistor and the precharge disconnecting switch are connected in series to each other and in parallel with the main disconnecting switch core; and
the plurality of high-and-low-voltage tabs further comprise a precharge low-voltage positive-electrode tab (580) and a precharge low-voltage negative-electrode tab (590), a first end of the precharge low-voltage positive-electrode tab and a first end of the precharge low-voltage negative-electrode tab are respectively connected to the precharge disconnecting switch, and a second end of the precharge low-voltage positive-electrode tab and a second end of the precharge low-voltage negative-electrode tab are respectively plugged into the circuit board for electrical connection with the low-voltage loop.

15. The power distribution apparatus according to claim 14, wherein the precharge disconnecting switch has a precharge high-voltage positive-electrode tab (191) and a precharge high-voltage negative-electrode tab (192), the precharge resistor has a resistor high-voltage tab (181), the circuit protector and the precharge resistor are electrically connected to each other through contact, and the precharge high-voltage positive-electrode tab, a precharge high-voltage negative-electrode tab, and the resistor high-voltage tab are plugged into the circuit board for electrical connection with a portion of the precharge loop integrated on the circuit board; or
the precharge disconnecting switch has the precharge high-voltage positive-electrode tab and the precharge high-voltage negative-electrode tab, the precharge resistor has a resistor high-voltage positive-electrode tab (182) and a resistor high-voltage negative-electrode tab (183), and the precharge high-voltage positive-electrode tab, the precharge high-voltage negative-electrode tab, the resistor high-voltage positive-electrode tab, and the resistor high-voltage negative-electrode tab are plugged into the circuit board for electrical connection with a portion of the precharge loop integrated on the circuit board.

16. The power distribution apparatus according to claim 14, wherein the precharge loop further comprises:
a precharge tab (171), the second terminal of the circuit protector overlapping with the first terminal of the main positive disconnecting switch core for electrical connection, a first end of the precharge tab being overlapped at an overlapping position between the second terminal of the circuit protector and the first terminal of the main positive disconnecting switch core, and a second end of the precharge tab being plugged into the circuit board and electrically connected to a portion of the precharge loop integrated on the circuit board.

17. The power distribution apparatus according to claim 16, wherein the precharge tab is integrally formed with the second terminal of the circuit protector.

18. The power distribution apparatus according to claim 14, wherein the precharge disconnecting switch, the precharge resistor, the main positive disconnecting switch core, the main negative disconnecting switch core, and the low-voltage connection part are arranged in sequence along the length direction of the base; and
the precharge disconnecting switch, the precharge resistor and the circuit protector are arranged along the width direction of the base.

19. The power distribution apparatus according to claim 14, wherein the base is configured with a main positive disconnecting switch core installation groove (101), a main negative disconnecting switch core installation groove (102), a precharge disconnecting switch installation groove (103), and a precharge resistor installation groove (104);
the main positive disconnecting switch core is fixed to the main positive disconnecting switch core installation groove through thermal conductive potting of glue;
the main negative disconnecting switch core is fixed to the main negative disconnecting switch core installation groove through thermal conductive potting of glue;
the precharge disconnecting switch is clamped in the precharge disconnecting switch installation groove or fixed to the precharge disconnecting switch installation groove through thermal conductive potting of glue; and
the precharge resistor is clamped in the precharge resistor installation groove.

20. The power distribution apparatus according to any one of claims 1 to 19, wherein the base comprises:
a base body (105), at least a portion of the high-voltage loop being arranged on the base body, and the circuit board being arranged on the base body; and
a panel (106), the panel being connected to the base body, and the high-voltage connection part and the low-voltage connection part being fixed on the panel.

21. The power distribution apparatus according to claim 20, wherein the base body and the panel are one piece or separate pieces.

22. A battery pack (2), comprising:
a housing (800);
the power distribution apparatus (1) according to any one of claims 1 to 21, the power distribution apparatus being arranged in the housing, and the high-voltage connection part (110) and the low-voltage connection part (120) being exposed from the housing; and
a battery module (700), the battery module being located in the housing and electrically connected to the module positive-electrode connection end (210) and the module negative-electrode connection end (220) respectively.

23. A vehicle (3), comprising the battery pack (2) according to claim 22 and a load (900) electrically connected to the battery pack.
